(19) Europäisches Patentamt
European Patent Office
Office européen des brevets

(11) **EP 2 624 397 B1**

(12) **EUROPEAN PATENT SPECIFICATION**

(45) Date of publication and mention
of the grant of the patent:
**02.04.2014 Bulletin 2014/14**

(51) Int Cl.:
*H02H 3/08* *(2006.01)*        *G01R 31/08* *(2006.01)*

(21) Application number: **12153825.0**

(22) Date of filing: **03.02.2012**

(54) **Method and apparatus for determining direction of fault**

Verfahren und Vorrichtung zur Bestimmung der Fehlerrichtung

Procédé et appareil de détermination de direction de défaut

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.08.2013 Bulletin 2013/32**

(73) Proprietor: **ABB Technology AG
8050 Zürich (CH)**

(72) Inventors:
• **Wahlroos, Ari
00380 Helsinki (FI)**
• **Altonen, Janne
00380 Helsinki (FI)**

(74) Representative: **Kolster Oy Ab
Iso Roobertinkatu 23
PO Box 148
00121 Helsinki (FI)**

(56) References cited:
**EP-A1- 1 331 715        EP-A1- 2 278 676
WO-A1-2008/148428        US-A1- 2009 088 989
US-B1- 6 584 417**

• **EISSA M M: "Evaluation of a New Current
Directional Protection Technique Using Field
Data", IEEE TRANSACTIONS ON POWER
DELIVERY, IEEE SERVICE CENTER, NEW YORK,
NY, US, vol. 20, no. 2, 1 April 2005 (2005-04-01),
pages 566-572, XP011129251, ISSN: 0885-8977,
DOI: 10.1109/TPWRD.2005.844356**

**Description**

FIELD OF THE INVENTION

The present invention relates to determining the direction of a fault in a three-phase electric network.

BACKGROUND OF THE INVENTION

A reliable indication of a fault direction, i.e. whether the fault is in a forward or reverse direction from a measuring point, can be critical in power system protection when a fault current can flow in both directions through the measuring point. Correct directional information is important for the selective operation of a protection system so that only e.g. a faulted feeder or feeder section becomes correctly isolated.

There are several methods for fault direction determination in power system protection. A typical implementation of a directional element is such that first measured current(s) and voltage(s) are digitally sampled and then converted into complex phasors with a magnitude and a phase angle (polar format), or equivalently with a real and imaginary part (Cartesian format). Directional determination can be based on e.g. any of the following electric phasor quantities (typically calculated at fundamental frequency):

- Impedance $\quad \overline{Z} = R + j * X$
- Admittance $\quad \overline{Y} = G + j * B$
- Power $\quad \overline{S} = P + j * Q$
- Current $\quad \overline{I} = I \cos(phi) + j * 1 \sin(phi)$

Where $\overline{Z}$ = Impedance, R = Resistance, X = Reactance, $\overline{Y}$ = Admittance, G = Conductance, B = Susceptance, $\overline{S}$ = Apparent power, P = Real power, Q = Reactive power, $\overline{I}$ = Current, Icos(phi) = Real-part of current, Isin(phi) = Imaginary part of current, phi = Phase angle difference between voltage and current, or reference current and current.

In impedance and current based protection directionality can be derived from voltages and currents basically by evaluating quotient $\overline{U/I}$, i.e. phase angle difference between the voltage and current phasors. Examples of such protection functions include directional overcurrent protection and distance protection. Directionality derived from admittance calculation $\overline{I/U}$ can be applied to neutral admittance protection applicable to earth-fault protection in high-impedance earthed systems. Instead of admittance calculation, power calculation $\overline{I*U}$ can be utilized in wattmetric and varmetric protection functions.

Voltage phasor $\overline{U}$ and current phasor $\overline{I}$ can be either phase quantities (phase current, phase-to-earth voltage, phase-to-phase voltage) typically applied in short-circuit protection) or symmetrical components (positive sequence, negative sequence or zero sequence component, typically applied in earth-fault protection).

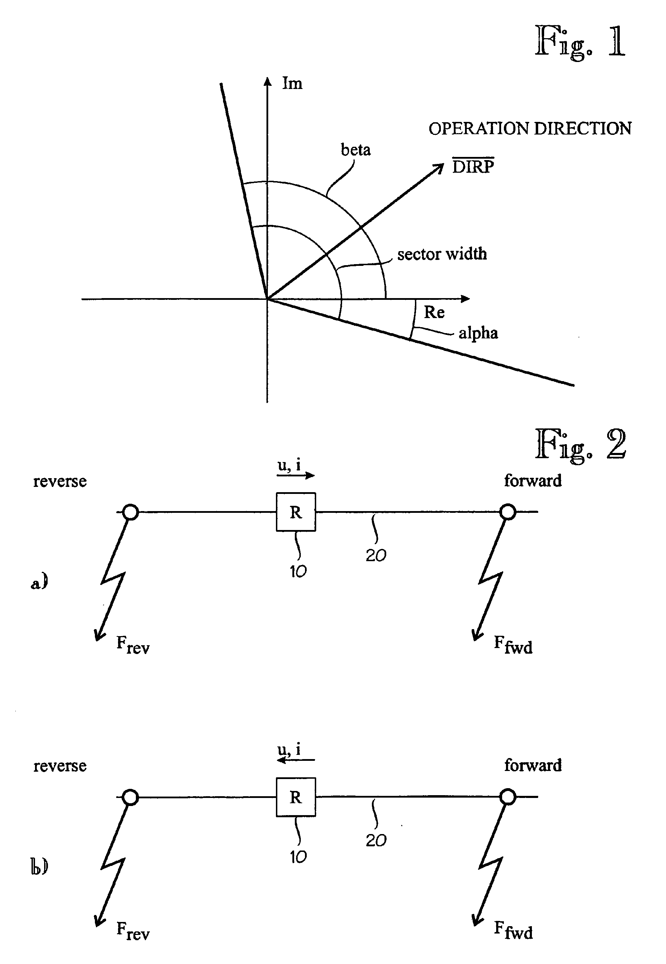

A directional operation characteristic of the fault direction function is typically presented on a complex plane with a real (Re) and imaginary (Im) axis. Figure 1 shows an example of a directional operation characteristic with two boundary lines defining the operation sector. In the example the first boundary line is at an angle alpha and the second boundary line is at an angle beta. Both angles have the same reference: the positive real-axis. The quantity defining the directionality (for example impedance, admittance, power or current) is presented in the diagram as a phasor with a real and imaginary part, or equivalently with a magnitude and a phase angle, pointing to specific direction from the origin (0,0). This phasor is compared with operation sector boundary lines (typically two, but at least one). If phasor $\overline{DIRP}$ lies inside the operation sector, then the direction matches the predefined/set operation direction (forward or reverse). Such directional evaluation can be done by comparing the directional phasor quantity $\overline{DIRP}$ with operation sector boundary lines at discrete time instants $t_1$, $t_2$, etc. and by thus determining the direction of the fault.

Document M. M. Eissa, "Evaluation of A New Current Directional Protection Technique Using Field Data", IEEE Transactions on Power Delivery, vol. 20, no. 2, pp. 566-572, April 2005, discloses an example of a current polarized directional element technique to determine the fault direction on a transmission line. The post-fault current signal and a directional reference current signal are used. A directional current element is derived from these quantities. The directional normal power flow before fault occurrence is also used. The voltage signal is excluded from the study after fault occurrence.

Document EP 1331715 discloses an example of a digital directional relay that converts a voltage value and a current value of a power system into digital voltage data and digital current data by periodic sampling and determines a direction of a fault using the digital voltage data and the digital current data. In the digital directional relay, a variation in unbalanced component voltage and a variation in unbalanced component current are computed using both voltage data at a reference point in time and voltage data at a point in time elapsed from the reference point in time by a given sampling interval and using both current data at reference time and current data at time elapsed from the reference time by a given sampling interval, respectively. A relationship in phase between these variations is obtained to determine whether a forward fault or a reverse fault occurs.

Document EP 2278676 discloses an example of a fault direction indicator device for indicating a direction of a fault on a transmission line of a power distribution system. The fault direction indicator device comprises an input section adapted to receive transmission line data, the transmission line data including local fault-direction indicative data measured by a measuring unit at the measurement location. The transmission line data includes, from the local fault-direction indicative data, only a current signal. The fault direction indicator device further comprises a decision logic section operatively connected to the input section, the decision logic section comprising a first fault direction determining program for determining the fault direction from the transmission line data and for outputting the determined fault direction as a first fault direction indicator.

In electrical systems a problem relating to such directional evaluation is the possible unstable characteristic of the directional phasor quantities (impedance, admittance, power or current, for example) during the fault. Such instability originates primarily from the fact that assumptions of constant frequency and amplitude in phasor calculation are often not valid in practical power systems. In practice, during the fault, the amplitudes and frequencies of voltages and currents are not constant, but may vary. Especially the amplitude of a measured signal may encounter high amplitude intermittent disturbances in the form of spikes. Also the non-linear characteristics of the primary network and devices, e.g. non-linear network components, such as saturable reactors or saturable instrument transformers, or non-linear characteristics of loads, can produce fluctuating levels of harmonics in the measured electric quantities, which are an error source in the traditional phasor calculation. Furthermore, a fault arc has inherently an unstable and non-linear characteristic, which can result in instability of the directional phasor quantities.

The result of this instability is that the directional decision may often become unreliable, which may lead to loss of dependability or security of the protection: e.g. the faulty feeder may not be detected and the healthy feeders may be falsely seen as being faulty and therefore falsely tripped. An example of this is a re-striking earth-fault in a Petersen coil earthed network, where the currents and voltages can be highly irregular and distorted in shape. Therefore, the value of the directional phasor quantity used in fault protection for a directional decision can have a very chaotic behavior in time, i.e. values of the directional phasor quantity determined at different time instants can vary significantly. This can often result in loss-of-selectivity of power system protection.

BRIEF DESCRIPTION OF THE INVENTION

An object of the present invention is to provide a method and an apparatus for implementing the method so as to overcome the above problem or at least to alleviate the problem. The objects of the invention are achieved by a method, a computer program product and an apparatus which are characterized by what is stated in the independent claims. The preferred embodiments of the invention are disclosed in the dependent claims.

The invention is based on the idea of using a cumulative phasor sum of at least two values, determined at different instants of time, of an electric phasor quantity at a measuring point as a value for the directional phasor quantity. Alternatively, the invention is based on the idea of using a quotient of two cumulative phasor sums as a value for the directional phasor quantity such that the first cumulative phasor sum is a sum of at least two values, determined at different instants of time, of a first electric phasor quantity at the measuring point and the second cumulative phasor sum is a sum of at least two values, determined at different instants of time, of a second electric phasor quantity at the measuring point.

An advantage of the invention is that it can result in great stabilization of the quantities utilized in directional protection and it can provide great improvement in the security and dependability of the directional evaluation of a fault in an electric network. Additionally the setting of the directional protection becomes easier and more accurate as the measurement results reflect the true parameters of the network despite the above mentioned disturbances in the electric phasor quantities. The operation of the protection can be made more stable and accurate even with highly distorted input signals.

BRIEF DESCRIPTION OF THE DRAWINGS

In the following the invention will be described in greater detail by means of preferred embodiments with reference to the accompanying drawings, in which

Figure 1 is an example of an operation characteristic according to an embodiment;
Figure 2 is an example of an an electric network;
Figures 3a)-c) are diagrams illustrating the calculation of the cumulative phasor sum according to an embodiment;
Figures 3d)-f) are examples of directional operation characteristics according to embodiments;
Figure 4 is an illustration of the calculation of the quotient of two cumulative phasor sums according to an embodiment;

Figure 5 is example of an operation characteristic according to an embodiment;
Figure 6 is example of an operation characteristic according to an embodiment; and
Figure 7 is example of an operation characteristic according to an embodiment.

DETAILED DESCRIPTION OF THE INVENTION

The application of the invention is not limited to any specific system, but it can be used in connection with various three-phase electric systems to determine the direction of a fault such as an earth-fault or a short-circuit fault.

The electric power system in which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

Figure 2 is a simplified diagram illustrating an example of an electric network in which the invention can be applied. For the sake of simplicity, the figure shows only the components necessary for understanding the invention. The network can be e.g. a medium voltage (e.g. 20 kV) distribution network. Figure 2 shows a protective relay unit R, 10 located at an electric line 20. It should be noted that there may be any number of relay units, electric lines and other network elements in the electric network. The network is a three-phase network, although, for the sake of clarity, the phases are not shown in the figure. In the exemplary network of Figure 2, the functionality of the invention may be located in the relay unit (R) 10. It is also possible that, for instance, only some measurements are performed at the location of the relay unit 10 and the results are then transmitted to some other unit or units (not shown in Figure 2) in another location for further processing. In other words, the relay unit 10 could be a mere measuring unit, while the functionality of the invention, or part of it, could be located in some other unit or units. A fault, such as an earth-fault or a short-circuit fault, occurring in the electric network may be detected e.g. by the protective relay 10 or by other protective equipment associated with the electric network. In case of a short-circuit fault, the fault detection may be based on e.g. over-current or under-impedance condition and in case of an earth-fault, the fault detection can be based on e.g. residual overvoltage- or residual overcurrent condition. Also other means for detecting a fault may be utilized. Typically said fault detection then releases the directional determination to decide whether the fault is located either in a reverse or in a forward direction. Figure 2a illustrates a situation, where the relay 10 is to set to operate for faults in the forward direction ($F_{fwd}$). Faults in the reverse direction ($F_{rev}$) do not result in operation, but could be signalled e.g. for blocking purposes. Figure 2b illustrates a situation, where the relay 10 is to set to operate for faults in the reverse direction ($F_{rev}$). Operation may be a tripping or a blocking action. Faults in the forward direction ($F_{fwd}$) in this case do not result in operation. In practice there may be simultaneously many instances of directional protection functions in operation, some of them providing tripping and some of them providing blocking.

Current and voltage values possibly needed in the different embodiments may be obtained by a suitable measuring arrangement including e.g. current and voltage transducers (not shown separately in the figures). In most of the existing protection systems, such values are readily available and thus the implementation of the various embodiments does not necessarily require any additional measuring arrangements.

According to an embodiment, after a fault has been detected in the electric network, a value for a directional phasor quantity is determined at a measuring point 10 in the three-phase electric network, and the determined value for the directional phasor quantity is compared with a directional operation characteristic to determine the direction of the fault F from the measuring point 10.

According to a first embodiment, the determination of the value for the directional phasor quantity comprises forming a cumulative phasor sum of at least two values, determined at different instants of time, of an electric phasor quantity at the measuring point 10; and setting the cumulative phasor sum as the value for the directional phasor quantity, $\overline{DIRP}=\overline{cumsumDIR}$. The sum is preferably formed separately for real- and/or imaginary parts. In other words, a cumulative phasor sum of two or more values of an electric quantity at the measuring point 10 determined at different instants of time and preferably calculated separately for real- and/or imaginary parts can be used as the directional phasor quantity $\overline{DIRP}$. Said two or more values of the electric quantity determined at different instants of time may be determined at constant intervals or at irregular intervals.

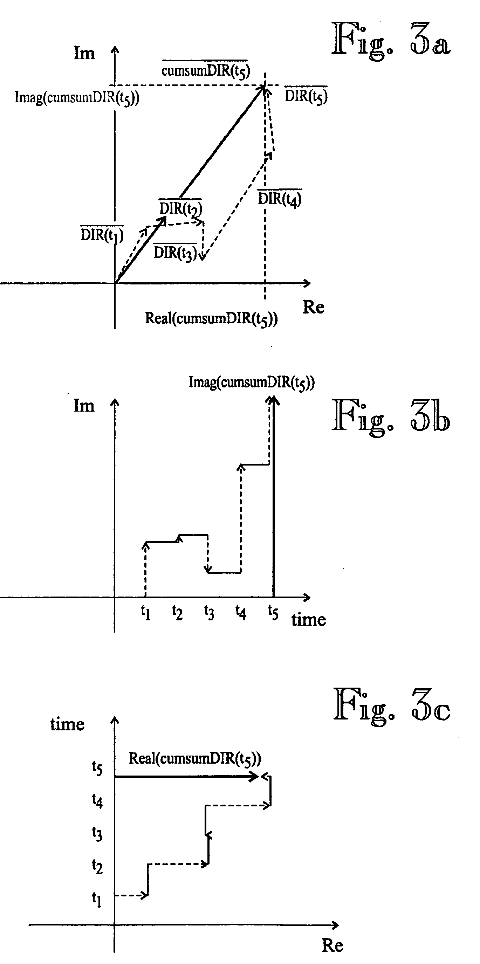

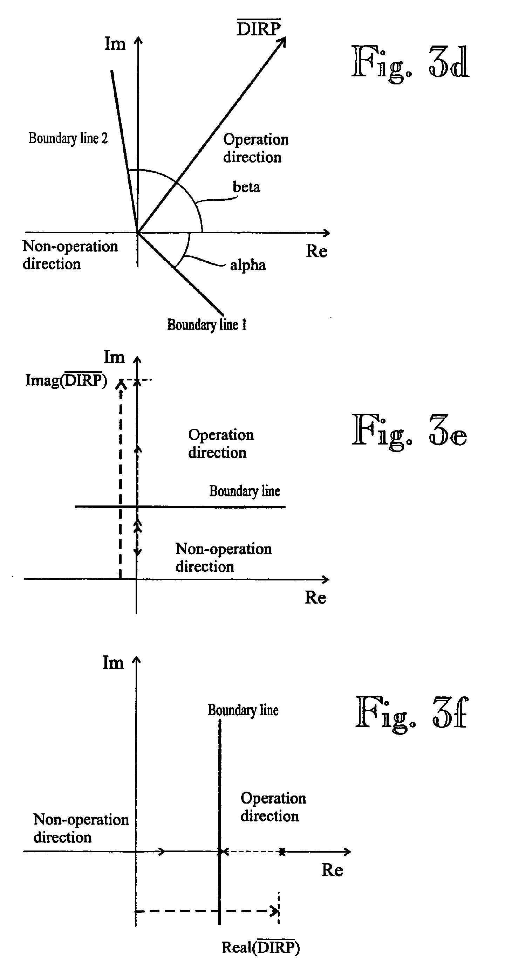

Figure 3a shows an example of a cumulative phasor sum, $\overline{cumsumDIR}$, which is a cumulative sum of phasor values of an electric phasor quantity at time instants $t_1$, $t_2$, $t_3$, $t_4$ and $t_5$. The electric phasor quantity can be e.g. one of the following: impedance, admittance, power or current. Furthermore, for deriving of the electric phasor quantity either phase quantities (phase current, phase-to-earth voltage, phase-to-phase voltage) or symmetrical components (positive sequence, negative sequence or zero-sequence component) can be applied. Also other electric quantities may be used. In Figures 3b and 3c the accumulation of an imaginary part and a real part of the cumulative phasor sum as a function of time is shown. The cumulative phasor sum or its real part and/or imaginary part, can be used for the directional decision according to an embodiment of the invention. Figure 3d shows an example of a directional operation characteristic in which two boundary lines define the boundary between the operation direction and the non-operation direction.

Typically the sector corresponding to the operation direction is set to the forward direction and the non-operation direction to the reverse direction. Figure 3d also shows a directional phasor quantity which corresponds to the cumulative phasor sum of Figure 3a, i.e. $\overline{DIRP}=\overline{cumsumDIR}$. In case the directional decision is based on either real-part or imaginary-part of the cumulative phasor sum, then the directional characteristic is a vertical line or a horizontal line in the complex plane as illustrated in Figure 3e (valid for a cumulative sum of the imaginary part of the directional phasor quantity) and 3f (valid for a cumulative sum of the real part of the directional phasor quantity).

According to an embodiment, the following can be performed at constant intervals or at irregular intervals: updating the cumulative phasor sum $\overline{cumsumDIR}$ (preferably separately for real- and/or imaginary parts) by adding a new value of the electric phasor quantity to the sum, setting the updated cumulative phasor sum as the value for the directional phasor quantity, and comparing the value for the directional phasor quantity with the directional operation characteristic to determine the direction of the fault from the measuring point. A prerequisite for adding a new value may be that its magnitude exceeds a minimum threshold so that its directionality can be considered to be valid. In other words, the cumulative phasor sum constituting the value for the directional phasor quantity can be updated at constant intervals or at irregular intervals by adding a new value of the electric quantity to the cumulative phasor sum, and the corresponding new value for the directional phasor quantity can then be used to determine the direction of the fault from the measuring point. The previously described process of accumulation can be done separately for real- and/or imaginary parts of an electrical phasor quantity.

According to an embodiment, the cumulative phasor sum $\overline{cumsumDIR}$ may be obtained according to the following equation:

$$\overline{cumsumDIR}(k) = \mathrm{Re}(\overline{cumsumDIR}(k)) + j * \mathrm{Im}(\overline{cumsumDIR}(k))$$

$$= \sum_{i=m}^{k} \overline{DIR}(i) = \sum_{i=m}^{k}\left(\mathrm{Re}(\overline{DIR}(i)) + j * \mathrm{Im}(\overline{DIR}(i))\right) \qquad \text{Eq. 1}$$

Where

$\overline{DIR}$ is an electric quantity defining the directionality in a phasor format at a discrete time instance
$m$ is a start index number corresponding to discrete time instance $t_1$
k is an index number corresponding to discrete time instance $t_k$ occurring after time instance $t_1$

According to an embodiment, the value of the electric phasor quantity $\overline{DIR}$ (e.g. impedance, admittance, power or current as described above) is typically based on the fundamental frequency component of the electric quantity, but it can also consist of a sum of a fundamental frequency component of the electric quantity and at least one harmonic frequency component of the electric quantity. The suggested electric phasor quantity can be of form:

$$\overline{DIR} = \overline{DIR}_1 + \sum_2^p \overline{DIR}_n \qquad \text{Eq. 2}$$

Where
$\overline{DIR}_1$ *is* the electric phasor quantity calculated at the fundamental frequency at a discrete time instance

$\overline{DIR}_n$ is the electric phasor quantity calculated at harmonic frequency $n*f_n$ at a discrete time instance, preferably such that the harmonic current and/or voltage magnitude exceeds a minimum measurable threshold level. Harmonics from 2 to p can be taken into account, where p corresponds to the highest order harmonic based on e.g. the used sampling frequency according to the Nyqvist theorem.

According to a second embodiment, the determination of the value for the directional phasor quantity comprises forming a first cumulative phasor sum of at least two values, determined at different instants of time, of a first electric phasor quantity at the measuring point, forming a second cumulative phasor sum of at least two values, determined at different instants of time, of a second electric phasor quantity at the measuring point, and setting a quotient of the first cumulative phasor sum and the second cumulative phasor sum as the value for the directional phasor quantity. In other words, a quotient of two cumulative phasor sums of values of two different electric quantities at the measuring point 10 can be used as the directional phasor quantity. Each of the two cumulative sums can be formed in a similar way as already described above. The following equation 3 shows how the stabilized directional phasor quantity $\overline{DIRP}(k)^{stabilized}$ can be calculated on the basis of two cumulative phasor sums (the first sum $\overline{cumsum1}(k)$ and the second sum $\overline{cumsum2}(k)$):

$$\overline{DIRP}(k)^{stabilized} = \overline{cumsum1}(k) / \overline{cumsum2}(k) = \text{Re}\left(\overline{DIRP}(k)^{stabilized}\right) + j * \text{Im}\left(\overline{DIRP}(k)^{stabilized}\right)$$

$$\text{Eq. 3}$$

The real- and imaginary part of stabilized directional phasor quantity $\overline{DIRP}(k)^{stabilized}$ can be obtained using the well-known rules of division of two complex quantities:

$$\text{Re}\left(\overline{DIRP}(k)^{stabilized}\right) = \frac{\text{Re}\left(\overline{cumsum1}(k)\right) * \text{Re}\left(\overline{cumsum2}(k)\right) + \text{Im}\left(\overline{cumsum1}(k)\right) * \text{Im}\left(\overline{cumsum2}(k)\right)}{\text{Re}\left(\overline{cumsum2}(k)\right) * \text{Re}\left(\overline{cumsum2}(k)\right) + \text{Im}\left(\overline{cumsum2}(k)\right) * \text{Im}\left(\overline{cumsum2}(k)\right)}$$

$$\text{Im}\left(\overline{DIRP}(k)^{stabilized}\right) = \frac{\text{Im}\left(\overline{cumsum1}(k)\right) * \text{Re}\left(\overline{cumsum2}(k)\right) - \text{Re}\left(\overline{cumsum1}(k)\right) * \text{Im}\left(\overline{cumsum2}(k)\right)}{\text{Re}\left(\overline{cumsum2}(k)\right) * \text{Re}\left(\overline{cumsum2}(k)\right) + \text{Im}\left(\overline{cumsum2}(k)\right) * \text{Im}\left(\overline{cumsum2}(k)\right)}$$

The two electric quantities from which the cumulative phasor sums are calculated can be e.g. a voltage quantity and a current quantity in which case the sums become $\overline{cumsumU}(k)$ and $\overline{cumsumI}(k)$, respectively. Thus, the quotient of the cumulative phasor sums of the two electric quantities can result in a stabilized impedance or admittance quantities:

$$\overline{Z}(k)^{stabilized} = \overline{cumsumU}(k) / \overline{cumsumI}(k) \qquad \text{Eq. 4a}$$

$$\overline{Y}(k)^{stabilized} = \overline{cumsumI}(k) / \overline{cumsumU}(k) \qquad \text{Eq. 4b}$$

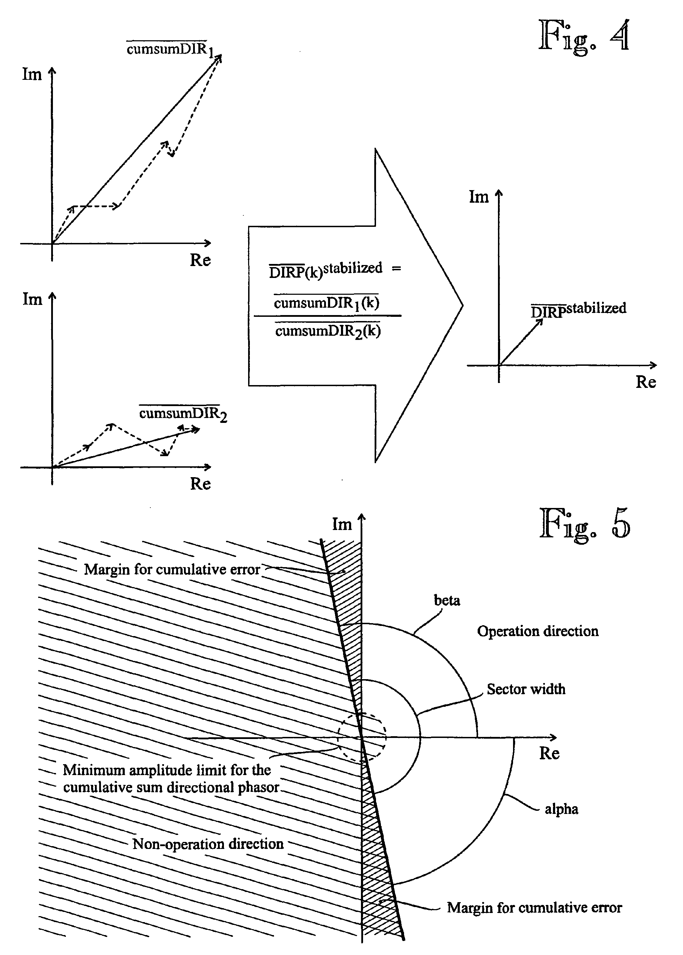

Such quantity, $\overline{DIRP}(k)^{stabilized}$, is stabilized by amplitude and direction (equivalently real and imaginary parts). That is, by diving two cumulative phasor sum quantities, the result is a stabilized non-cumulative phasor quantity. This is illustrated in Figure 4. Such quantity, preferably admittance or impedance (or their real and/or imaginary parts), may then be used in electrical system protection similarly as the same phasor quantities without stabilization. The voltage phasor quantity or current phasor quantity can be either a phase quantity (phase current, phase-to-earth voltage, phase-to-phase voltage) or a symmetrical component (positive sequence, negative sequence or zero-sequence component). Also other electric phasor quantities may be used. According to an embodiment, the values of the two electric phasor quantities (e.g. voltage and current) are typically based on the fundamental frequency component of the electric quantity in question, but they can also consist of a sum of a fundamental frequency component of the electric quantity in question and at least one harmonic frequency component of the electric quantity in question as already described above in connection with the first embodiment.

According to an embodiment, the following can be performed at constant intervals or at irregular intervals: updating the first cumulative phasor sum and the second cumulative phasor sum by adding a new value of the first electric phasor quantity to the first cumulative phasor sum and by adding a new value of the second electric phasor quantity to the second cumulative phasor sum, setting a quotient of the updated first cumulative phasor sum and the updated second cumulative phasor sum as the value for the directional phasor quantity, and comparing the value for the directional phasor quantity with the directional operation characteristic to determine the direction of the fault from the measuring point. In other words, the two cumulative phasor sums, whose quotient constitutes the value for the directional phasor quantity, can be updated at predetermined intervals by adding new value of the electric quantities to the cumulative phasor sums and the corresponding new value for the directional phasor quantity can then be used to determine the direction of the fault from the measuring point.

According to an embodiment, the value for the directional phasor quantity according to the second embodiment, when it is an admittance value, can be further converted to a current value by applying a complex conjugate and multiplying it with a nominal phase-to-earth voltage of the system $U_n$:

$$\bar{I}(k)^{stabilized} = conj\left(\overline{Y}(k)^{stabilized}\right) \cdot U_n \qquad \text{Eq. 5}$$

The obtained stabilized current value can then be used e.g. to control the operation of the directional protection according to the first embodiment. For example, for forward operation it may be additionally required that the directional phasor $\overline{DIRP}$ is within the operate sector and that the amplitude, or the value of its real- or imaginary part, of the current $\bar{I}(k)^{stabilized}$ exceeds a preset threshold.

The use of the cumulative phasor sum, $\overline{cumsumDIR(k)}$, as a directional phasor quantity $\overline{DIRP}$ according to the above embodiments means that the resulting directional phasor builds up, i.e. its amplitude accumulates, during the time of a fault and its directionality is then determined by all the individual phasors included in the cumulative phasor sum. On the other hand, the "weight" of an individual new phasor added to the cumulative phasor sum decreases in time. That is, it can be said that the resulting directional phasor points to the direction of the highest momentum or energy of the individual phasors at different time intervals. This can result in great stabilization of the directional phasor and provide great improvement in the security and dependability of the directional evaluation.

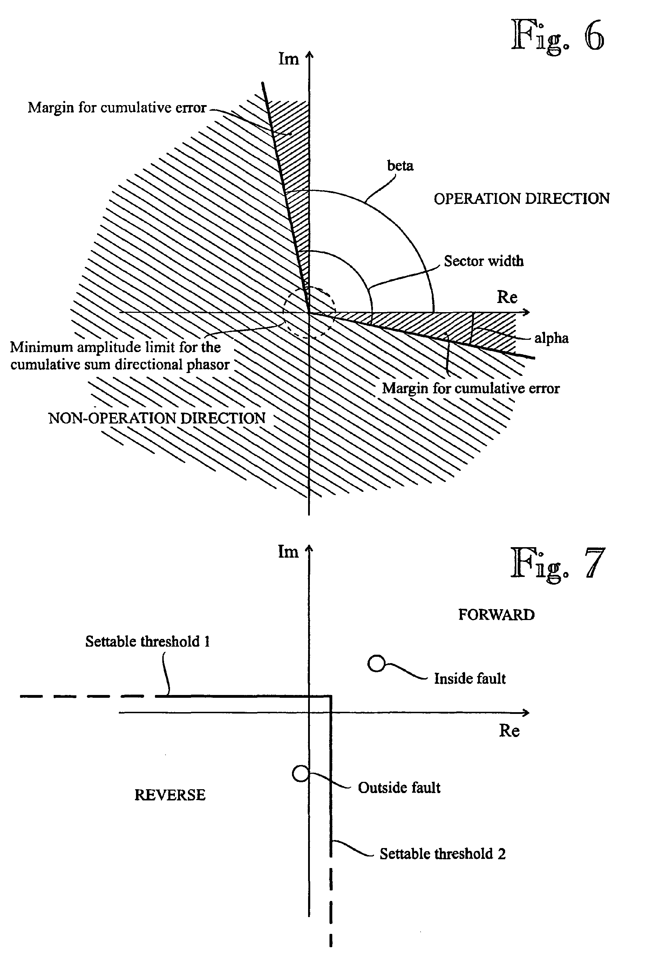

As the possible measurement error in the directional cumulative phasor sum $\overline{cumsumDIR}(k)$ accumulates, the directional characteristics applicable for this approach can have at least one tilted boundary line providing margin for this cumulative error. This is the case if both real- and imaginary parts of cumulative phasor sum are simultaneously used in directional evaluation. An example of this is illustrated in Figure 5 which presents an example of a directional operation characteristic for earth fault protection (e.g admittance, locosphi, Wattmetric, phase angle criterion). Figure 6 presents an example of a directional operation characteristic for short-circuit direction protection (e.g. directional over-current, distance protection). Both operation characteristics show two margins for the cumulative error. The width of these margins depends on the accuracy of the measurements in question. Both operation characteristics further show a minimum amplitude limit for the cumulative sum phasor. Figure 7 presents an example of a directional operation characteristic applicable with the second embodiment where the resulting stabilized directional phasor quantity $\overline{DIRP}(k)^{stabilized}$ is admittance. For impedance, operation characteristic as shown in Figure 6 can be used. The operation characteristic of Figure 7 defines forward and reverse operation areas with two settable thresholds. It should be noted that the operation characteristics shown in Figures 5, 6 and 7 are only examples of possible operation characteristics. Other kind of operation characteristics could be used instead.

Further security for a directional decision can be obtained by monitoring e.g.:

- the cumulative value of a real part of the cumulative sum directional phasor $\overline{cumsumDIR}(k)$ in time and/or
- the cumulative value of an imaginary part of the cumulative sum directional phasor $\overline{cumsumDIR}(k)$ in time and/or
- the amplitude, or the value of it's real- or imaginary part, of $\overline{DIRP}(k)^{stabilized}$ in time.

The value of $\overline{cumsumDIR}(k)$ may also be "normalized" by dividing it with the number of how many individual phasors the cumulative phasor sum consists of. Also the increase speed of the cumulative phasor sum $\overline{cumsumDIR}(k)$ may be used for security purposes in order to secure a correct directional decision. Typically, it may be assumed that the cumulating speed is higher for a faulty feeder than for a healthy feeder. The cumulative value of $\overline{cumsumDIR}(k)$ may also be limited to some predetermined value. This may be used in order to avoid any numerical over-flow problems.

The main advantage of the above embodiments is that they stabilize the directional phasor quantity and improve the security and dependability of directional decision during irregular and distorted current and voltage waveforms. One example, where such stabilization may be required, is a re-striking earth fault in Petersen coil earthed systems, when fundamental frequency based methods are traditionally applied, such as: locos, losin, wattmetric, varmetric or admittance. But it can also be applied to cases, where the directional phasor quantity is based on a frequency other than fundamental, e.g. harmonic frequencies.

An apparatus according to any one of the above embodiments, or a combination thereof, may be implemented as a single unit or as two or more units that are configured to implement the functionality of the various embodiments. Here the term 'unit' refers generally to a physical or logical entity, such as a physical device or a part thereof or a software routine. One or more of these units may reside in the protective relay unit 10, for example. More generally, the above embodiments can be realized in an IED (Intelligent Electronic Device) residing in the electric network.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations, such as program instructions, and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, and output means for outputting e.g. fault alarms and/or control data e.g. for controlling protection equipment such as switches, disconnectors and circuit-breakers. It is also possible to use a specific integrated circuit or circuits, and/or discrete components and devices for implementing the functionality according to any one of the embodiments.

The invention can be implemented in existing system elements, such as various protective relays or similar devices, or by using separate dedicated elements or devices in a centralized or distributed manner.

Present protective devices for electric systems, such as protective relays or generally IEDs, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept may be implemented in various ways. The invention and its embodiments are not limited to the examples described above but may vary within the scope of the claims.

**Claims**

**1.** A method for determining a direction of a fault in a three-phase electric network, the method comprising:

> detecting a fault in the three-phase electric network;
> determining, after a fault has been detected in the three-phase electric network, a value for a directional phasor quantity at a measuring point in the three-phase electric network; and
> comparing the determined value for the directional phasor quantity with a directional operation characteristic to determine the direction of the fault from the measuring point, **characterized in that** the determining of the value for the directional phasor quantity comprises:

> > a) forming a cumulative phasor sum of at least two values, determined at different instants of time, of an electric phasor quantity at the measuring point; and setting the cumulative phasor sum as the value for the directional phasor quantity,
> > or

b) forming a first cumulative phasor sum of at least two values, determined at different instants of time, of a first electric phasor quantity at the measuring point; forming a second cumulative phasor sum of at least two values, determined at different instants of time, of a second electric phasor quantity at the measuring point; and setting a quotient of the first cumulative phasor sum and the second cumulative phasor sum as the value for the directional phasor quantity.

2. A method according to claim 1, **characterized in that**, as per alternative a), the method comprises performing at constant intervals or at irregular intervals:

updating the cumulative phasor sum by adding a new value of the electric phasor quantity to the cumulative phasor sum;
setting the updated cumulative phasor sum as the value for the directional phasor quantity; and
comparing the value for the directional phasor quantity with the directional operation characteristic to determine the direction of the fault from the measuring point.

3. A method according to claim 1 or 2, **characterized in that**, as per alternative a), the electric phasor quantity is one of the following: impedance, admittance, power or current.

4. A method according to claim 1, 2 or 3, **characterized in that**, as per alternative a), the value of the electric phasor quantity consists of a sum of a fundamental frequency component of the electric phasor quantity and at least one harmonic frequency component of the electric phasor quantity.

5. A method according to claim 1, **characterized in that**, as per alternative b), the method comprises performing at constant intervals or at irregular intervals:

updating the first cumulative phasor sum and the second cumulative phasor sum by adding a new value of the first electric phasor quantity to the first cumulative phasor sum and by adding a new value of the second electric phasor quantity to the second cumulative phasor sum;
setting a quotient of the updated first cumulative phasor sum and the updated second cumulative phasor sum as the value for the directional phasor quantity; and
comparing the value for the directional phasor quantity with the directional operation characteristic to determine the direction of the fault from the measuring point.

6. A method according to claim 1 or 5, **characterized in that**, as per alternative b), the first electric phasor quantity is current and the second electric phasor quantity is voltage, or the first electric phasor quantity is voltage and the second electric phasor quantity is current.

7. A method according to claim 1, 5 or 6, **characterized in that**, as per alternative b), the value of the first electric phasor quantity consists of a sum of a fundamental frequency component of the first electric phasor quantity and at least one harmonic frequency component of the first electric phasor quantity, and the value of the second electric phasor quantity consists of a sum of a fundamental frequency component of the second electric phasor quantity and at least one harmonic frequency component of the second electric phasor quantity.

8. A computer program product comprising computer program code, wherein the execution of the program code in a computer comprising input means for receiving measurement and/or control data causes the computer to carry out the steps of the method according to any one of claims 1 to 7.

9. An apparatus for determining a direction of a fault in a three-phase electric network, the apparatus comprising:

means (10) for determining a value for a directional phasor quantity at a measuring point in the three-phase electric network after a fault has been detected in the three-phase electric network; and
means (10) for comparing the determined value for the directional phasor quantity with a directional operation characteristic to determine the direction of the fault from the measuring point, **characterized in that** the means (10) for determining the value for the directional phasor quantity comprises:

a) means for forming a cumulative phasor sum of at least two values, determined at different instants of time, of an electric phasor quantity at the measuring point; and means for setting the cumulative phasor sum as the value for the directional phasor quantity,

or

b) means for forming a first cumulative phasor sum of at least two values, determined at different instants of time, of a first electric phasor quantity at the measuring point; means for forming a second cumulative phasor sum of at least two values, determined at different instants of time, of a second electric phasor quantity at the measuring point; and means for setting a quotient of the first cumulative phasor sum and the second cumulative phasor sum as the value for the directional phasor quantity.

10. An apparatus according to claim 9, **characterized in that**, as per alternative a), the means for determining (10) the value for the directional phasor quantity are configured to:

update, at constant intervals or at irregular intervals, the cumulative phasor sum by adding a new value of the electric phasor quantity to the cumulative phasor sum; and
set the updated cumulative phasor sum as a new value for the directional phasor quantity, wherein the means (10) for comparing the determined value for the directional phasor quantity are configured to:

compare the new value for the directional phasor quantity with the directional operation characteristic to determine the direction of the fault from the measuring point.

11. An apparatus according to claim 9 or 10, **characterized in that**, as per alternative a), the electric phasor quantity is one of the following: impedance, admittance, power or current.

12. An apparatus according to claim 9, 10 or 11, **characterized in that**, as per alternative a), the value of the electric phasor quantity consists of a sum of a fundamental frequency component of the electric phasor quantity and at least one harmonic frequency component of the electric phasor quantity.

13. An apparatus according to claim 9, **characterized in that**, as per alternative b), the means (10) for determining the value for the directional phasor quantity are configured to:

update the first cumulative phasor sum and the second cumulative phasor sum by adding a new value of the first electric phasor quantity to the first cumulative phasor sum and by adding a new value of the second electric phasor quantity to the second cumulative phasor sum; and
set a quotient of the updated first cumulative phasor sum and the updated second cumulative phasor sum as the value for the directional phasor quantity, wherein the means (10) for comparing the determined value for the directional phasor quantity are configured to:

comparing the new value for the directional phasor quantity with the directional operation characteristic to determine the direction of the fault from the measuring point.

14. An apparatus according to claim 9 or 13, **characterized in that**, as per alternative b), the first electric phasor quantity is current and the second electric phasor quantity is voltage, or the first electric phasor quantity is voltage and the second electric phasor quantity is current.

15. An apparatus according to claim 9, 13 or 14, **characterized in that**, as per alternative b), the value of the first electric phasor quantity consists of a sum of a fundamental frequency component of the first electric phasor quantity and at least one harmonic frequency component of the first electric phasor quantity, and the value of the second electric phasor quantity consists of a sum of a fundamental frequency component of the second electric phasor quantity and at least one harmonic frequency component of the second electric phasor quantity.

**Patentansprüche**

1. Verfahren zum Bestimmen einer Fehlerrichtung in einem dreiphasigen elektrischen Netzwerk, wobei das Verfahren umfasst:

das Erkennen eines Fehlers in dem dreiphasigen elektrischen Netzwerk;
nach dem Erkennen eines Fehlers in dem dreiphasigen elektrischen Netzwerk, das Bestimmen des Werts der Richtungsvektorgröße an einem Messpunkt in dem dreiphasigen elektrischen Netzwerk; und
das Vergleichen des bestimmten Werts der Richtungsvektorgröße mit einer Richtungsbetriebscharakteristik, um die Richtung des Fehlers von dem Messpunkt aus zu bestimmen, **dadurch gekennzeichnet, dass** das Bestimmen des Werts der Richtungsvektorgröße aufweist:

a) Bilden einer kumulativen Vektorsumme aus mindestens zwei zu unterschiedlichen Zeitpunkten bestimmten Werten einer elektrischen Vektorgröße an dem Messpunkt; und Einstellen der kumulativen Vektorsumme als den Wert der Richtungsvektorgröße;
oder

b) Bilden einer ersten kumulativen Vektorsumme aus mindestens zwei zu unterschiedlichen Zeitpunkten bestimmten Werten einer ersten elektrischen Vektorgröße an dem Messpunkt; Bilden einer zweiten kumulativen Vektorsumme aus mindestens zwei zu unterschiedlichen Zeitpunkten bestimmten Werten einer zweiten elektrischen Vektorgröße an dem Messpunkt; und Einstellen eines Quotienten aus der ersten kumulativen Vektorsumme und der zweiten kumulativen Vektorsumme als Wert der Richtungsvektorgröße.

2. Verfahren nach Anspruch 1, **dadurch gekennzeichnet, dass** nach der Alternative a) das Verfahren die Durchführung der folgenden Schritte in konstanten Intervallen oder in unregelmäßigen Intervallen aufweist:

Aktualisieren der kumulativen Vektorsumme durch Addieren eines neuen Werts der elektrischen Vektorgröße zu der kumulativen Vektorsumme;
Einstellen der aktualisierten kumulativen Vektorsumme als Wert der Richtungsvektorgröße; und
Vergleichen des Werts der Richtungsvektorgröße mit der Richtungsbetriebskennlinie zur Bestimmung der Richtung des Fehlers von dem Messpunkt aus.

3. Verfahren nach Anspruch 1 oder 2, **dadurch gekennzeichnet, dass** nach der Alternative a) die elektrische Vektorgröße eine der folgenden ist: Impedanz, Admittanz, Leistung oder Strom.

4. Verfahren nach Anspruch 1, 2 oder 3, **dadurch gekennzeichnet, dass** nach der Alternative a) der Wert der elektrischen Vektorgröße aus der Summe einer Grundfrequenzkomponente der elektrischen Vektorgröße und mindestens einer harmonischen Frequenzkomponente der elektrischen Vektorgröße gebildet ist.

5. Verfahren nach Anspruch 1, **dadurch gekennzeichnet, dass** nach der Alternative b) das Verfahren die Durchführung der folgenden Schritte in konstanten Intervallen oder in unregelmäßigen Intervallen aufweist:

Aktualisieren der ersten kumulativen Vektorsumme und der zweiten kumulativen Vektorsumme durch Addieren eines neuen Werts der ersten elektrischen Vektorgröße zu der ersten kumulativen Vektorsumme und durch Addieren eines neuen Werts der zweiten elektrischen Vektorgröße zu der zweiten kumulativen Vektorsumme;
Einstellen eines Quotienten aus der aktualisierten ersten kumulativen Vektorsumme und der aktualisierten zweiten kumulativen Vektorsumme als den Wert der Richtungsvektorgröße; und
Vergleichen des Werts der Richtungsvektorgröße mit der Richtungsbetriebskennlinie zur Bestimmung der Richtung des Fehlers von dem Messpunkt aus.

6. Verfahren nach Anspruch 1 oder 5, **dadurch gekennzeichnet, dass** nach der Alternative b) die erste elektrische Vektorgröße der Strom und die zweite elektrische Vektorgröße die Spannung ist, oder die erste elektrische Vektorgröße die Spannung und die zweite elektrische Vektorgröße der Strom ist.

7. Verfahren nach Anspruch 1, 5 oder 6, **dadurch gekennzeichnet, dass** nach der Alternative b) der Wert der ersten elektrischen Vektorgröße aus der Summe aus einer Grundfrequenzkomponente der ersten elektrischen Vektorgröße und mindestens einer harmonischen Frequenzkomponente der ersten elektrischen Vektorgröße gebildet ist, und der Wert der zweiten elektrischen Vektorgröße aus der Summe aus einer Grundfrequenzkomponente der zweiten elektrischen Vektorgröße und mindestens einer harmonischen Frequenzkomponente der zweiten elektrischen Vektorgröße gebildet ist.

8. Computerprogrammprodukt mit einem Computerprogrammcode, bei welchem die Ausführung des Programmcodes in einem Computer, welcher Eingabeeinrichtungen für den Empfang von Mess- und/oder Steuerdaten aufweist, den Computer veranlasst, die Schritte des Verfahrens nach einem der Ansprüche 1 bis 7 durchzuführen.

9. Vorrichtung zur Bestimmung der Fehlerrichtung in einem dreiphasigen elektrischen Netzwerk, wobei die Vorrichtung aufweist:

eine Einrichtung (10) zum Bestimmen eines Werts der Richtungsvektorgröße an einem Messpunkt in dem dreiphasigen elektrischen Netzwerk nach der Erkennung eines Fehlers in dem dreiphasigen elektrischen Netzwerk; und

eine Einrichtung (10) zum Vergleichen des bestimmten Werts der Richtungsvektorgröße mit einer Richtungsbetriebscharakteristik, um die Richtung des Fehlers von dem Messpunkt aus zu bestimmen, **dadurch gekennzeichnet, dass** die Einrichtung (10) zum Bestimmen des Werts der Richtungsvektorgröße aufweist:

a) eine Einrichtung zum Bilden einer kumulativen Vektorsumme aus mindestens zwei zu unterschiedlichen Zeitpunkten bestimmten Werten einer elektrischen Vektorgröße an dem Messpunkt; und eine Einrichtung zum Einstellen der kumulativen Vektorsumme als den Wert der Richtungsvektorgröße;

oder

b) eine Einrichtung zum Bilden einer ersten kumulativen Vektorsumme aus mindestens zwei zu unterschiedlichen Zeitpunkten bestimmten Werten einer ersten elektrischen Vektorgröße an dem Messpunkt; eine Einrichtung zum Bilden einer zweiten kumulativen Vektorsumme aus mindestens zwei zu unterschiedlichen Zeitpunkten bestimmten Werten einer zweiten elektrischen Vektorgröße an dem Messpunkt; und eine Einrichtung zum Einstellen eines Quotienten aus der ersten kumulativen Vektorsumme und der zweiten kumulativen Vektorsumme als Wert der Richtungsvektorgröße.

10. Vorrichtung nach Anspruch 9, **dadurch gekennzeichnet, dass** nach der Alternative a) die Einrichtung (10) zum Bestimmen des Werts der Richtungsvektorgröße konfiguriert ist, um

die kumulative Vektorsumme durch Addieren eines neuen Werts der elektrischen Vektorgröße zu der kumulativen Vektorsumme zu aktualisieren;

die aktualisierte kumulative Vektorsumme als Wert der Richtungsvektorgröße einzustellen, wobei die Einrichtung (10) zum Vergleichen des bestimmten Werts für die Richtungsvektorgröße ausgebildet ist, um:

den Wert der Richtungsvektorgröße mit der Richtungsbetriebskennlinie zu vergleichen, um die Richtung des Fehlers von dem Messpunkt aus zu bestimmen.

11. Vorrichtung nach Anspruch 9 oder 10, **dadurch gekennzeichnet, dass** nach der Alternative a) die elektrische Vektorgröße eine der folgenden ist: Impedanz, Admittanz, Leistung oder Strom.

12. Vorrichtung nach Anspruch 9, 10 oder 11, **dadurch gekennzeichnet, dass** nach der Alternative a) der Wert der elektrischen Vektorgröße aus der Summe einer Grundfrequenzkomponente der elektrischen Vektorgröße und mindestens einer harmonischen Frequenzkomponente der elektrischen Vektorgröße gebildet ist.

13. Vorrichtung nach Anspruch 9, **dadurch gekennzeichnet, dass** nach der Alternative b) die Einrichtung (10) zum Bestimmen des Werts der Richtungsvektorgröße konfiguriert ist, um

die erste kumulative Vektorsumme und die zweite kumulative Vektorsumme durch Addieren eines neuen Werts der ersten elektrischen Vektorgröße zu der ersten kumulativen Vektorsumme und durch Addieren eines neuen Werts der zweiten elektrischen Vektorgröße zu der zweiten kumulativen Vektorsumme zu aktualisieren;

einen Quotienten aus der aktualisierten ersten kumulativen Vektorsumme und der aktualisierten zweiten kumulativen Vektorsumme als den Wert der Richtungsvektorgröße einzustellen, wobei die Einrichtung (10) zum Vergleichen des bestimmten Werts für die Richtungsvektorgröße ausgebildet ist, um:

den Wert der Richtungsvektorgröße mit der Richtungsbetriebskennlinie zu vergleichen, um die Richtung des Fehlers von dem Messpunkt aus zu bestimmen.

14. Vorrichtung nach Anspruch 9 oder 13, **dadurch gekennzeichnet, dass** nach der Alternative b) die erste elektrische Vektorgröße der Strom und die zweite elektrische Vektorgröße die Spannung ist, oder die erste elektrische Vektorgröße die Spannung und die zweite elektrische Vektorgröße der Strom ist.

15. Vorrichtung nach Anspruch 9, 13 oder 14, **dadurch gekennzeichnet, dass** nach der Alternative b) der Wert der ersten elektrischen Vektorgröße aus der Summe aus einer Grundfrequenzkomponente der ersten elektrischen Vektorgröße und mindestens einer harmonischen Frequenzkomponente der ersten elektrischen Vektorgröße gebildet ist, und der Wert der zweiten elektrischen Vektorgröße aus der Summe aus einer Grundfrequenzkomponente der zweiten elektrischen Vektorgröße und mindestens einer harmonischen Frequenzkomponente der zweiten elektrischen Vektorgröße gebildet ist.

**Revendications**

1.  Procédé pour déterminer une direction d'un défaut dans un réseau électrique triphasé, le procédé comprenant :

    la détection d'un défaut dans le réseau électrique triphasé ;
    la détermination, après qu'un défaut ait été détecté dans le réseau électrique triphasé, d'une valeur pour une quantité de phaseurs directionnels en un point de mesure dans le réseau électrique triphasé ; et
    la comparaison de la valeur déterminée pour la quantité de phaseurs directionnels à une caractéristique de fonctionnement directionnel afin de déterminer la direction du défaut à partir du point de mesure, **caractérisé en ce que** la détermination de la valeur pour la quantité de phaseurs directionnels comprend :

    a) la formation d'une somme de phaseurs cumulative d'au moins deux valeurs, déterminées à des instants dans le temps différents, d'une quantité de phaseurs électriques au point de mesure ; et l'établissement de la somme de phaseurs cumulative comme valeur pour la quantité de phaseurs directionnels ;
    ou
    b) la formation d'une première somme de phaseurs cumulative d'au moins deux valeurs, déterminées à des instants dans le temps différents, d'une première quantité de phaseurs électriques au point de mesure ;
    la formation d'une deuxième somme de phaseurs cumulative d'au moins deux valeurs, déterminées à des instants dans le temps différents, d'une deuxième quantité de phaseurs électriques au point de mesure ;
    et l'établissement d'un quotient de la première somme de phaseurs cumulative et de la deuxième somme de phaseurs cumulative comme valeur pour la quantité de phaseurs directionnels.

2.  Procédé selon la revendication 1, **caractérisé en ce que**, en ce qui concerne l'alternative a), le procédé comprend la réalisation, à des intervalles constants ou à des intervalles irréguliers :

    de la remise à jour de la somme de phaseurs cumulative par l'addition d'une nouvelle valeur de la quantité de phaseurs électriques à la somme de phaseurs cumulative ;
    de l'établissement de la somme de phaseurs cumulative remise à jour comme valeur pour la quantité de phaseurs directionnels ; et
    de la comparaison de la valeur pour la quantité de phaseurs directionnels à la caractéristique de fonctionnement directionnel afin de déterminer la direction du défaut à partir du point de mesure.

3.  Procédé selon la revendication 1 ou 2, **caractérisé en ce que**, en ce qui concerne l'alternative a), la quantité de phaseurs électriques est l'une de ce qui suit : l'impédance, l'admittance, la puissance ou le courant.

4.  Procédé selon la revendication 1, 2 ou 3, **caractérisé en ce que**, en ce qui concerne l'alternative a), la valeur de la quantité de phaseurs électriques est constituée par une somme d'une composante de fréquence fondamentale de la quantité de phaseurs électriques et d'au moins une composante de fréquence harmonique de la quantité de phaseurs électriques.

5.  Procédé selon la revendication 1, **caractérisé en ce que**, en ce qui concerne l'alternative b), le procédé comprend la réalisation, à des intervalles constants ou à des intervalles irréguliers :

    de la remise à jour de la première somme de phaseurs cumulative et de la deuxième somme de phaseurs cumulative par l'addition d'une nouvelle valeur de la première quantité de phaseurs électriques à la première somme de phaseurs cumulative et par l'addition d'une nouvelle valeur de la deuxième quantité de phaseurs électriques à la deuxième somme de phaseurs cumulative ;
    de l'établissement d'un quotient de la première somme de phaseurs cumulative remise à jour et de la deuxième somme de phaseurs cumulative remise à jour comme valeur pour la quantité de phaseurs directionnels ; et
    de la comparaison de la valeur pour la quantité de phaseurs directionnels à la caractéristique de fonctionnement directionnel afin de déterminer la direction du défaut à partir du point de mesure.

6.  Procédé selon la revendication 1 ou 5, **caractérisé en ce que**, en ce qui concerne l'alternative b), la première quantité de phaseurs électriques est le courant et la deuxième quantité de phaseurs électriques est la tension, ou la première quantité de phaseurs électriques est la tension et la deuxième quantité de phaseurs électriques est le courant.

7.  Procédé selon la revendication 1, 5 ou 6, **caractérisé en ce que**, en ce qui concerne l'alternative b), la valeur de la première quantité de phaseurs électriques est constituée par une somme d'une composante de fréquence fondamentale de la première quantité de phaseurs électriques et d'au moins une composante de fréquence harmonique de la première quantité de phaseurs électriques, et la valeur de la deuxième quantité de phaseurs électriques est constituée par une somme d'une composante de fréquence fondamentale de la deuxième quantité de phaseurs électriques et d'au moins une composante de fréquence harmonique de la deuxième quantité de phaseurs électriques.

8. Produit de programme informatique comprenant un code de programme informatique, dans lequel l'exécution du code de programme dans un ordinateur comprenant des moyens d'entrée pour recevoir des données de mesure et/ou de commande provoque l'exécution par l'ordinateur des étapes du procédé selon l'une quelconque des revendications 1 à 7.

9. Appareil pour déterminer une direction d'un défaut dans un réseau électrique triphasé, l'appareil comprenant :

des moyens (10) pour déterminer une valeur pour une quantité de phaseurs directionnels en un point de mesure dans le réseau électrique triphasé après qu'un défaut ait été détecté dans le réseau électrique triphasé ; et des moyens (10) pour comparer la valeur déterminée pour la quantité de phaseurs directionnels à une caractéristique de fonctionnement directionnel afin de déterminer la direction du défaut à partir du point de mesure, **caractérisé en ce que** les moyens (10) pour déterminer la valeur pour la quantité de phaseurs directionnels comprennent :

a) des moyens pour former une somme de phaseurs cumulative d'au moins deux valeurs, déterminées à des instants dans le temps différents, d'une quantité de phaseurs électriques au point de mesure ; et des moyens pour établir la somme de phaseurs cumulative comme valeur pour la quantité de phaseurs directionnels;
ou
b) des moyens pour former une première somme de phaseurs cumulative d'au moins deux valeurs, déterminées à des instants dans le temps différents, d'une première quantité de phaseurs électriques au point de mesure ; des moyens pour former une deuxième somme de phaseurs cumulative d'au moins deux valeurs, déterminées à des instants dans le temps différents, d'une deuxième quantité de phaseurs électriques au point de mesure ; et des moyens pour établir un quotient de la première somme de phaseurs cumulative et de la deuxième somme de phaseurs cumulative comme valeur pour la quantité de phaseurs directionnels.

10. Appareil selon la revendication 9, **caractérisé en ce que**, en ce qui concerne l'alternative a), les moyens pour déterminer (10) la valeur pour la quantité de phaseurs directionnels sont configurés de façon à :

remettre à jour, à des intervalles constants ou à des intervalles irréguliers, la somme de phaseurs cumulative par l'addition d'une nouvelle valeur de la quantité de phaseurs électriques à la somme de phaseurs cumulative ; et établir la somme de phaseurs cumulative remise à jour comme nouvelle valeur pour la quantité de phaseurs directionnels, les moyens (10) pour comparer la valeur déterminée pour la quantité de phaseurs directionnels étant configurés de façon à :

comparer la nouvelle valeur pour la quantité de phaseurs directionnels à la caractéristique de fonctionnement directionnel afin de déterminer la direction du défaut à partir du point de mesure.

11. Appareil selon la revendication 9 ou 10, **caractérisé en ce que**, en ce qui concerne l'alternative a), la quantité de phaseurs électriques est l'une de ce qui suit : l'impédance, l'admittance, la puissance ou le courant.

12. Appareil selon la revendication 9, 10 ou 11, **caractérisé en ce que**, en ce qui concerne l'alternative a), la valeur de la quantité de phaseurs électriques est constituée par une somme d'une composante de fréquence fondamentale de la quantité de phaseurs électriques et d'au moins une composante de fréquence harmonique de la quantité de phaseurs électriques.

13. Appareil selon la revendication 9, **caractérisé en ce que**, en ce qui concerne l'alternative b), les moyens (10) pour déterminer la valeur pour la quantité de phaseurs directionnels sont configurés de façon à :

remettre à jour la première somme de phaseurs cumulative et la deuxième somme de phaseurs cumulative par l'addition d'une nouvelle valeur de la première quantité de phaseurs électriques à la première somme de phaseurs cumulative et par l'addition d'une nouvelle valeur de la deuxième quantité de phaseurs électriques à la deuxième somme de phaseurs cumulative ; et

établir un quotient de la première somme de phaseurs cumulative remise à jour et de la deuxième somme de phaseurs cumulative remise à jour comme valeur pour la quantité de phaseurs directionnels, les moyens (10) pour comparer la valeur déterminée pour la quantité de phaseurs directionnels étant configurés de façon à :

comparer la nouvelle valeur pour la quantité de phaseurs directionnels à la caractéristique de fonctionnement directionnel afin de déterminer la direction du défaut à partir du point de mesure.

**14.** Appareil selon la revendication 9 ou 13, **caractérisé en ce que**, en ce qui concerne l'alternative b), la première quantité de phaseurs électriques est le courant et la deuxième quantité de phaseurs électriques est la tension, ou la première quantité de phaseurs électriques est la tension et la deuxième quantité de phaseurs électriques est le courant.

**15.** Appareil selon la revendication 9, 13 ou 14, **caractérisé en ce que**, en ce qui concerne l'alternative b), la valeur de la première quantité de phaseurs électriques est constituée par une somme d'une composante de fréquence fondamentale de la première quantité de phaseurs électriques et d'au moins une composante de fréquence harmonique de la première quantité de phaseurs électriques, et la valeur de la deuxième quantité de phaseurs électriques est constituée par une somme d'une composante de fréquence fondamentale de la deuxième quantité de phaseurs électriques et d'au moins une composante de fréquence harmonique de la deuxième quantité de phaseurs électriques.

Fig. 1

Fig. 2

Fig. 3a

Fig. 3b

Fig. 3c

$\overline{DIRP}$

Im

Boundary line 2

Operation
direction

beta

Non-operation
direction

Re

alpha

Boundary line 1

**Fig. 3d**

Im

Imag($\overline{DIRP}$)

Operation
direction

Boundary line

Non-operation
direction

Re

**Fig. 3e**

Im

Boundary line

Operation
direction

Non-operation
direction

Re

Real($\overline{DIRP}$)

**Fig. 3f**

# Fig. 4

$\overline{cumsumDIR}_1$

Im

Re

Im

$\overline{cumsumDIR}_2$

Re

$$\overline{DIRP}(k)^{stabilized} = \frac{\overline{cumsumDIR}_1(k)}{\overline{cumsumDIR}_2(k)}$$

Im

$\overline{DIRP}^{stabilized}$

Re

# Fig. 5

Im

Margin for cumulative error

beta

Operation direction

Sector width

Re

Minimum amplitude limit for the
cumulative sum directional phasor

alpha

Non-operation direction

Margin for cumulative error

Fig. 6

Fig. 7

## REFERENCES CITED IN THE DESCRIPTION

**Patent documents cited in the description**

- EP 1331715 A

- EP 2278676 A

**Non-patent literature cited in the description**

- **M. M. EISSA.** Evaluation of A New Current Directional Protection Technique Using Field Data. *IEEE Transactions on Power Delivery,* April 2005, vol. 20 (2), 566-572